Europäisches Patentamt

(19) European Patent Office

Office européen des brevets

(11) Numéro de publication: **0 346 203**
**A1**

## (12) DEMANDE DE BREVET EUROPEEN

(21) Numéro de dépôt: 89401542.9

(22) Date de dépôt: 05.06.89

(51) Int. Cl.4: **G 01 R 1/10**

(30) Priorité: 06.06.88 FR 8807489

(43) Date de publication de la demande:
13.12.89 Bulletin 89/50

(84) Etats contractants désignés:
AT BE CH DE ES GB GR IT LI LU NL SE

(71) Demandeur: **RADIO CONTROLE S.A.**
**13, rue Clément Boyer**
**F-69000 Lyon (Rhone) (FR)**

(72) Inventeur: **Palencher, Jacques**
**26, rue Général Saussier**
**Troyes (Aube) (FR)**

**Jaillant, Gabriel**
**Route de Brienne**
**Creney Pont Sainte Marie (Aube) (FR)**

(74) Mandataire: **Cabinet Pierre HERRBURGER**
**115, Boulevard Haussmann**
**F-75008 Paris (FR)**

(54) Appareil de mesure ferromagnétique.

(57) Appareil de mesure ferromagnétique comportant, une bobine (1) pourvue d'un fût creux (2) et sur laquelle est réalisé un enroulement d'un fil conducteur, un équipage mobile (5) solidaire d'une aiguille (7) se déplaçant devant un cadran gradué entre une valeur zéro et une valeur maximum, cet équipage mobile étant solidaire d'une première palette métallique (19) se déplaçant, lors de la mesure d'une grandeur électrique, par rapport à une deuxième palette métallique fixée dans le fût creux de la bobine, en fonction du champ magnétique créé par l'enroulement, appareil caractérisé en ce qu'il comporte une troisième palette métallique (21, 22) fixée dans le fût creux de la bobine, de façon à coopérer avec la palette mobile (19) pour freiner le pivotement de l'équipage mobile lorsque la grandeur électrique à mesurer tend à déplacer l'aiguille (7) de l'équipage mobile au-delà de la valeur maximum de la graduation.

FIG 1

## Description

### Appareil de mesure ferromagnétique

L'invention concerne un appareil de mesure ferromagnétique.

On connaît déjà des appareils de mesure dits "à échelle moteur" dont le cadran gradué, devant lequel se déplace l'aiguille indicatrice, se prolonge, au-delà de la valeur maximum de la graduation, par une zone non graduée mais qui peut être atteinte par l'aiguille lorsque l'appareil est parcouru par une surintensité fugitive telle que celle qui apparaît lors de la mise en route d'un moteur.

Cette disposition permet de reporter la butée mécanique de l'aiguille au-delà de cette zone dite d'échelle moteur du cadran, afin d'empêcher ou tout au moins de réduire la violence du choc de l'aiguille contre cette butée mécanique de fin de course lors d'une surintensité fugitive.

La présente invention a pour but d'apporter des perfectionnements à ces appareils et concerne à cet effet un appareil de mesure ferromagnétique comportant, une bobine pourvue d'un fût creux et sur laquelle est réalisé un enroulement d'un fil conducteur, un équipage mobile, solidaire d'une aiguille se déplaçant devant un cadran gradué entre une valeur zéro et une valeur maximum, cet équipage mobile étant solidaire d'une première palette métallique se déplaçant, lors de la mesure d'une grandeur électrique, par rapport à une deuxième palette métallique fixée dans le fût creux de la bobine, en fonction du champ magnétique créé par l'enroulement, appareil caractérisé en ce qu'il comporte une troisième palette métallique fixée dans le fût creux de la bobine, de façon à coopérer avec la palette mobile pour freiner le pivotement de l'équipage mobile lorsque la grandeur électrique à mesurer tend à déplacer l'aiguille de l'équipage mobile au-delà de la valeur maximum de la graduation.

Suivant une autre caractéristique de l'invention, la troisième palette est fixée sur la paroi interne du fût creux.

L'invention est représentée à titre d'exemple non limitatif sur les dessins ci-joints dans lesquels :

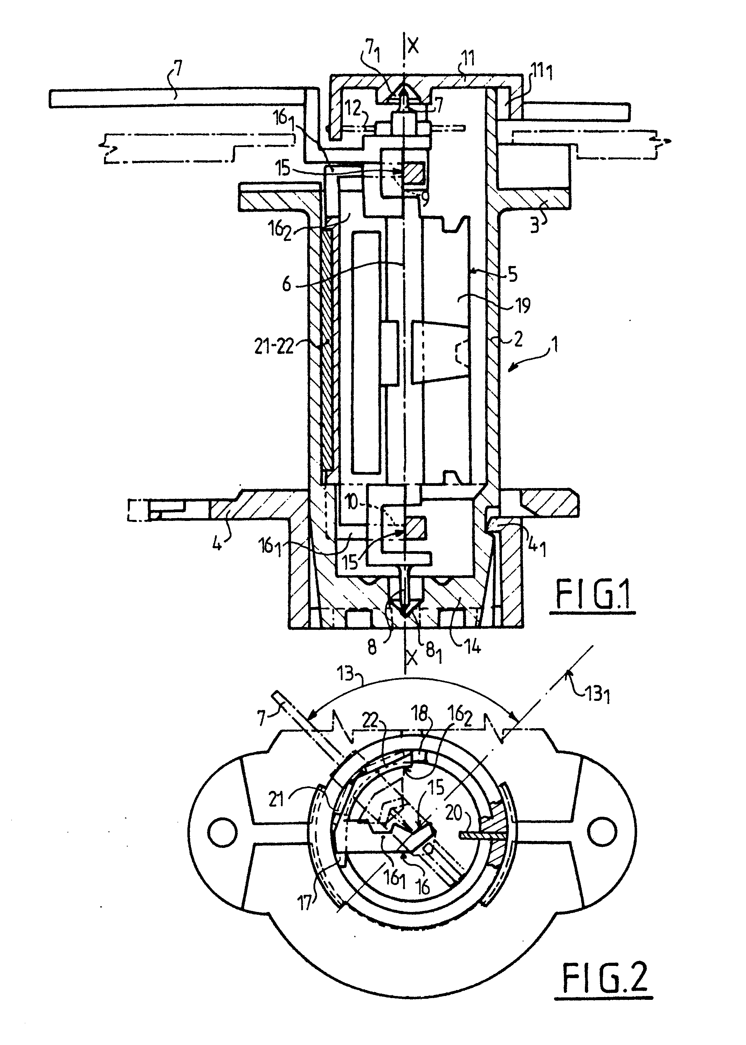

- la figure 1 est une vue en coupe schématique axiale d'un mode de réalisation de l'appareil de mesure conforme à l'invention,

- la figure 2 est une vue de dessus de la figure 1, la raquette de remise à zéro de l'appareil étant ôtée et l'équipage mobile étant représenté en pointillés.

L'appareil ferromagnétique représenté sur les dessins ci-joints comprend une bobine 1 dont le fût creux 2 est réalisé en une seule pièce par moulage d'une matière plastique, avec le flasque supérieur 3, le flasque inférieur 4 étant encliqueté en $4_1$ à la base du fût 2.

L'équipage mobile 5 comprend un axe 6 solidaire de l'aiguille indicatrice 7, cet équipage mobile étant, dans l'exemple représenté, monté à pivotement suivant l'axe X-X, d'une part par l'intermédiaire de pointes de pivotage d'extrémité 7 et 8, d'autre part par des couteaux 9 et 10 disposés en alignement avec ces pointes de pivotage 7 et 8.

La pointe de pivotage 7 coopère à cet effet avec une portée conique $7_1$ formée dans une raquette 11 montée à pivotement par un assemblage à baïonnette $11_1$ à l'extrémité du fût 2 de la bobine 1. Cette raquette 11 est reliée à l'extrémité extérieure du ressort de rappel en spirale 12 dont l'extrémité centrale est immobilisée sur l'axe 6 de l'équipage mobile. Cette disposition permet, par le réglage angulaire de la position de la raquette 11, d'effectuer la remise à zéro de l'aiguille 7 sur le cadran gradué schématisé en 13 de l'appareil.

La pointe de pivotage 8 coopère avec une portée conique $8_1$ formée dans le fond 14 du fût creux 2.

Les couteaux 9 et 10 coopèrent chacun avec des dièdres 15 formés à l'extrémité des deux branches $16_1$ d'un étrier 16 dont la base $16_2$ forme approximativement un quart de cercle.

Cet étrier 16 est monté de manière amovible à l'intérieur du fût creux 2, par coulissement axial entre deux nervures 17 et 18 faisant saillie à l'intérieur du fût creux.

L'équipage mobile 5 comporte également une palette métallique 19 fixée à l'axe 6 de façon à être située radialement à l'intérieur du fût creux 2. Par ailleurs, ce fût creux 2 comporte également une palette métallique 20 fixée radialement en saillie à l'intérieur du fût dans une position telle que lorsque l'enroulement du fil conducteur formé sur la bobine 1 est parcouru par un courant, le champ magnétique créé engendre entre les palettes métalliques 19 et 20 une force de répulsion ayant tendance à faire pivoter l'aiguille 7 devant la graduation 13 d'un angle fonction de la valeur de la grandeur électrique à mesurer.

Conformément à l'invention, cet appareil de mesure ferromagnétique comporte également une troisième palette métallique destinée à constituer une butée magnétique visant à freiner et à limiter le déplacement de l'aiguille au-delà de la valeur maximum $13_1$ de la graduation 13 afin d'éviter ainsi de manière sûre toute détérioration de l'appareil de mesure lorsqu'il subit une surintensité fugitive.

Dans l'exemple représenté, cette troisième palette métallique est constituée par une double palette 21 et 22 placée tangentiellement à la face interne du fût entre la base $16_2$ de l'étrier 16 et cette face interne du fût.

Lorsque l'aiguille 7 dépasse la valeur maximum $13_1$ de la graduation 13, la force de répulsion existant entre la palette 19 et les palettes 21 et 22 tend à freiner puis à empêcher le pivotement de l'aiguille 7, cette force de répulsion étant d'autant plus importante que la déviation de l'aiguille 7 au-delà de la graduation maximum $13_1$ est importante.

Bien entendu, la position et les dimensions des palettes métalliques ainsi que la position des graduations 13 du cadran, seront déterminées de façon à tenir compte de la combinaison des différentes forces de répulsion en fonction de l'angle de déviation de l'aiguille, étant entendu que, au-delà de la graduation maximum $13_1$ la force de répulsion engendrée par les palettes 21 et 22 sur la palette 19 devient extrêmement prépondérante par rapport à l'action de répulsion exercée par la palette 20.

On notera également que dans l'exemple représenté, la troisième palette métallique fixe se compose de deux palettes 21 et 22. Cependant, selon les valeurs des grandeurs mesurées, ainsi que selon le secteur couvert par la graduation 13, cet appareil pourra comporter une seule palette 21 ou 22 disposée dans l'un ou l'autre des logements correspondants prévus dans la face externe de la base $16_1$ de l'étrier 16.

## Revendications

1) Appareil de mesure ferromagnétique comportant, une bobine (1) pourvue d'un fût creux (2) et sur laquelle est réalisé un enroulement d'un fil conducteur, un équipage mobile (5) solidaire d'une aiguille (7) se déplaçant devant un cadran gradué (13) entre une valeur zéro et une valeur maximum, cet équipage mobile étant solidaire d'une première palette métallique (19) se déplaçant, lors de la mesure d'une grandeur électrique, par rapport à une deuxième palette métallique (20) fixée dans le fût creux de la bobine, en fonction du champ magnétique créé par l'enroulement, appareil caractérisé en ce qu'il comporte une troisième palette métallique (21, 22) fixée dans le fût creux de la bobine, de façon à coopérer avec la palette mobile (19) pour freiner le pivotement de l'équipage mobile lorsque la grandeur électrique à mesurer tend à déplacer l'aiguille (7) de l'équipage mobile au-delà de la valeur maximum ($13_1$) de la graduation.

2) Appareil de mesure conforme à la revendication 1, caractérisé en ce que la troisième palette (21, 22) est fixée sur la paroi interne du fût creux (2).

3) Appareil de mesure conforme à l'une quelconque des revendications précédentes, caractérisé en ce que la troisième palette (19, 20) est fixée tangentiellement contre la paroi interne du fût creux.

4) Appareil de mesure conforme à l'une quelconque des revendications précédentes, caractérisé en ce que le fût creux comporte plusieurs logements pour recevoir, dans l'un et/ou l'autre de ces logements, la troisième palette fixe (19, 20).

5) Appareil de mesure conforme à l'une quelconque des revendications précédentes, caractérisé en ce que l'équipage mobile est monté à pivotement, d'une part, par des pointes de pivotage (7, 8) et des portées correspondantes ($7_1$, $8_1$), d'autre part par des couteaux (9, 10) et des portées correspondantes (15, 16), les couteaux ou leur portée étant formés sur un étrier (16) logé dans le fût (2), la troisième palette métallique (19, 20) étant maintenue dans le fût entre sa face interne et la base ($16_2$) de l'étrier.

EP 0 346 203 A1

FIG.1

FIG.2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | US-A-2 481 276  (ERISSON)<br>* Colonne 2, ligne 47 - colonne 3, ligne 18 *<br>--- | 1-3 | G 01 R   1/10 |
| A | DE-C-  421 129  (DA)<br>--- | | |
| A | DE-C-  512 048  (HARTMANN)<br>----- | | |

**DOMAINES TECHNIQUES RECHERCHES (Int. Cl.4)**

G 01 R

Le présent rapport a été établi pour toutes les revendications

| Lieu de la recherche | Date d'achèvement de la recherche | Examinateur |
|---|---|---|
| LA HAYE | 18-09-1989 | HOORNAERT W. |